# EUROPÄISCHE PATENTSCHRIFT

(11) **EP 2 157 843 B1**
(45) Veröffentlichungstag und Bekanntmachung des Hinweises auf die Patenterteilung: **11.05.2016**
(21) Anmeldenummer: 09008715.6
(22) Anmeldetag: 03.07.2009
(51) Int. Cl.: H05K 5/00, H04M 1/02

(54) **Elektrisches Installationsgerät**
Electric installation device
Appareil d'installation électrique

(30) Priorität: 23.08.2008 DE 102008039515
(43) Veröffentlichungstag der Anmeldung: 24.02.2010
(73) Patentinhaber: Albrecht Jung GmbH & Co. KG, 58579 Schalksmühle (DE)
(72) Erfinder: Kandt, Richard, 44803 Bochum (DE); Kohlhaas, Johannes, 58579 Schalksmühle (DE); Bonventre, Giancarlo, 58507 Lüdenscheid (DE); Gebhardt, Marc, 58579 Schalksmühle (DE)

(56) Entgegenhaltungen:
- EP-A1- 1 848 015
- US-A1- 2003 223 561

## Beschreibung

Die vorliegende Erfindung geht von einem gemäß Oberbegriff des Hauptanspruches konzipierten elektrischen Türkommunikationsgerät für Gebäude aus.

Elektrische Installationsgeräte sind in der Regel dafür vorgesehen, eine Vielzahl von in Gebäuden installierte Aktoren (Jalousieantriebe, Beleuchtungseinrichtungen, Fühler, Wächter usw.) bedarfsgerecht zu beeinflussen. Zu diesem Zweck sind die unterschiedlichsten Installationsgeräte, wie z. B. Schalter, Taster, Dimmer usw. bekannt geworden.

Durch die US 2003/223561 A1 ist ein dem Oberbegriff des Hauptanspruches entsprechendes elektrisches Türkommunikationsgerät bekannt geworden. Dieses elektrische Türkommunikationsgerät ist mit einer Bedienoberfläche und mit zumindest einem zur Aufnahme von Funktionselementen vorgesehenen Gehäuse versehen und weist zumindest eine im Gehäuse gehaltene erste Leiterplatte auf, welche mit einer Schnittstelle zum Anschluss zumindest einer weiteren Leiterplatte versehen ist. Das Gehäuse weist zudem zur Aufnahme zumindest einer weiteren Leiterplatte zumindest eine in eine offene Stellung und in eine geschlossene Stellung bringbare Schublade auf. Bei einer derartigen Anordnung ergibt sich jedoch durch die Schub- bzw. Zugbewegung ein vergleichsweise hoher Verschleiß an den miteinander in Verbindung tretenden Kontaktelementen, so dass bei einer nicht nur gelegentlichen Benutzung der Schublade Kontaktausfälle auftreten können.

Des Weiteren ist durch die DE 10 2006 018 796 A1 ein elektrisches Installationsgerät bekannt geworden, welches mit einer Bedienoberfläche versehen ist und welches zur Aufnahme von Funktionselementen ein Gehäuse aufweist, wobei eine erste Leiterplatte vorgesehen ist, an welche über entsprechende Kontaktstellen bzw. Schnittstellen zumindest eine weitere Leiterplatte angeschlossen werden kann. Oftmals besteht bei modernen elektrischen Installationsgeräten der Gebäudesystemtechnik die Notwendigkeit bzw. der Bedarf, dass diese funktionstechnisch z. B. um die Möglichkeit einer komfortablen Fernbedienung erweitert werden oder aber mit einem Update versehen werden können. Bei den vorliegenden Geräten ist die Realisierung solcher Notwendigkeiten bzw. Bedarfserfüllungen oftmals jedoch mit entsprechenden Schwierigkeiten verbunden.

Sind elektrische Installationsgeräte als Türkommunikationsgeräte ausgeführt, so sind diese in der Regel dafür vorgesehen, bei Bedarf eine Kommunikationsmöglichkeit zwischen einem Wohnungsinhaber und einem Besucher zu schaffen. Oftmals weist ein solches elektrisches Installationsgerät mehrere Betätigungstasten (z. B. Klingeltasten) auf, damit sich der Besucher beim ausgewählten Wohnungsinhaber bemerkbar machen kann. Außerdem sind solche elektrischen Türkommunikationsgeräte oftmals mit einer Lautsprechereinheit und einem Mikrophon versehen, damit der Wohnungsinhaber mit dem Besucher sprechen kann und danach entscheidet, ob diesem Einlass gewährt wird. Zu diesem Zweck sind solche elektrischen/elektronischen Türkommunikationsgeräte mit einer Öffnungstaste versehen. Vielfach sind solche elektrischen Türkommunikationsgeräte auch mit einer Funktionstaste ausgerüstet, um z. B. die Lichtanlage im Flur einschalten zu können. Auch bei solchen elektrischen Türkommunikationsgeräten besteht oftmals der Bedarf bzw. die Notwendigkeit einer funktionstechnischen Erweiterung, wie z. B. einer komfortablen Fernbedienung oder aber der Bedarf bzw. die Notwendigkeit ein Update vornehmen zu können, um z. B. ein neues oder verbessertes Betriebssystem einzulesen. Durch die EP 0 993 171 A2 ist z. B. ein entsprechendes Türkommunikationsgerät bekannt geworden. Bei solchen Türkommunikationsgeräten ist die Realisierung solcher Notwendigkeiten bzw. Bedarfserfüllungen ebenfalls mit entsprechenden Schwierigkeiten verbunden.

Der vorliegenden Erfindung liegt deshalb die Aufgabe zugrunde, ein elektrisches Installationsgerät bzw. ein Türkommunikationsgerät zu schaffen, bei welchem eine notwendige oder gewünschte funktionstechnische Erweiterung oder aber ein Update z. B. mit aktuelleren Betriebsdaten auf besonders einfache Art und Weise realisierbar ist bzw. durchgeführt werden kann.

Diese Aufgabe wird durch die im Hauptanspruch angegebenen Merkmale gelöst.

Bei einem solchermaßen ausgebildeten elektrischen Türkommunikationsgerät ist besonders vorteilhaft, dass eine die funktionstechnischen Erweiterungen bzw. das Update beinhaltende bzw. ermöglichende weitere Leiterplatte in eine im Gerät vorhandene Schublade eingelegt und durch Schließen der Schublade in ihre Funktionsstellung gebracht werden kann. Auch ein Austausch einer nicht mehr alle funktionstechnischen Gegebenheiten abdeckende bzw. nicht mehr den aktuellsten Update-Stand enthaltenen Leiterplatte ist somit auf einfache Art und Weise möglich. Dabei ist besonders vorteilhaft, dass beim Schließen der Schublade diese eine Schub-Hubbewegung ausführt, so dass die miteinander in Wirkverbindung kommenden Kontakte der ersten Leiterplatte und der weiteren Leiterplatte besonders verschleißschonend miteinander in Kontakt treten. Außerdem ist besonders vorteilhaft, dass beim Öffnen der Schublade diese eine Zug-Senkbewegung ausführt, so dass die in der Schublade befindliche weitere Leiterplatte auf besonders einfache Art und Weise ausgetauscht werden kann und die Kontakte der ersten Leiterplatte und der weiteren Leiterplatte besonders verschleißschonend wieder voneinander getrennt werden.

Ist die weitere Leiterplatte z. B. als Kommunikationsschnittstelle ausgeführt, ist es besonders vorteilhaft, dass über diese Kommunikationsschnittstelle drahtlos z. B. über eine Funkverbindung ein Datenaustausch oder aber eine Funktionserweiterung, wie z. B. eine Fernbedienmöglichkeit auf besonders komfortable Art und Weise realisiert werden bzw. erfolgen kann. Als Funkverbindung kann z. B. der Bluetooth-Standard zum Einsatz kommen, so dass die Kommunikation bzw. die Fernbedienung problemlos mittels eines handelsüblichen Handys durchführbar ist. Es können aber auch ohne weiteres andere Funkstandards, wie z. B. DECT, UMTS, GSM, WLAN, Bluetooth, Wimax, Edge, WUSB (Wireless USB) usw. zur Anwendung gelangen. Weiterhin ist hierdurch die Einbindung von Türkommunikationsgeräten in die Gebäudesystemtechnik bzw. in Hausnetzwerke mittels Standard-Netzwerkprotokollen, wie UDP (User Datagram Protocol) möglich.

Weitere vorteilhafte Ausgestaltungen sind in den Unteransprüchen angegeben. Anhand eines in den Zeichnungen näher dargestellten Ausführungsbeispieles sei der erfindungsgemäße Gegenstand näher erläutert. Dabei zeigen:

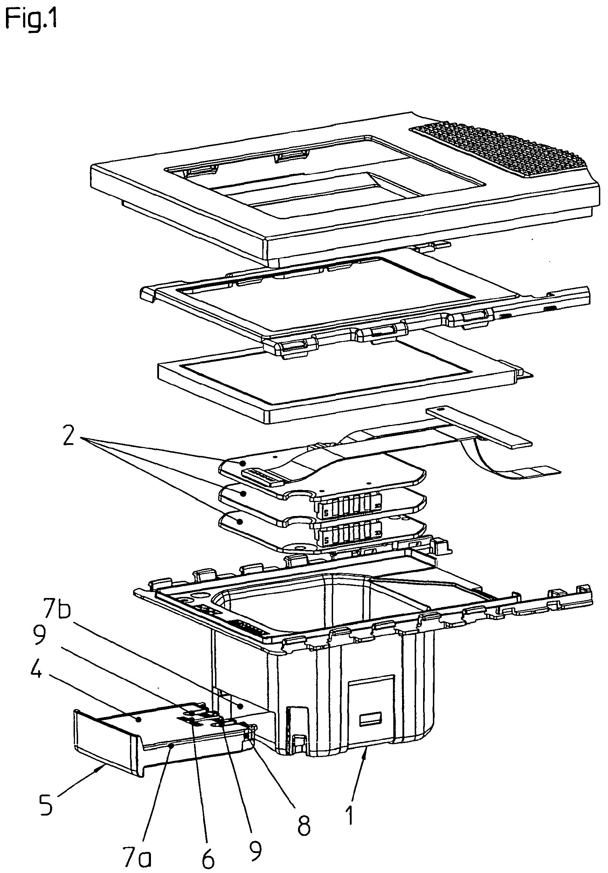

- Fig. 1:: prinziphaft ein elektrisches Türkommunikationsgerät räumlich in Explosionsdarstellung;

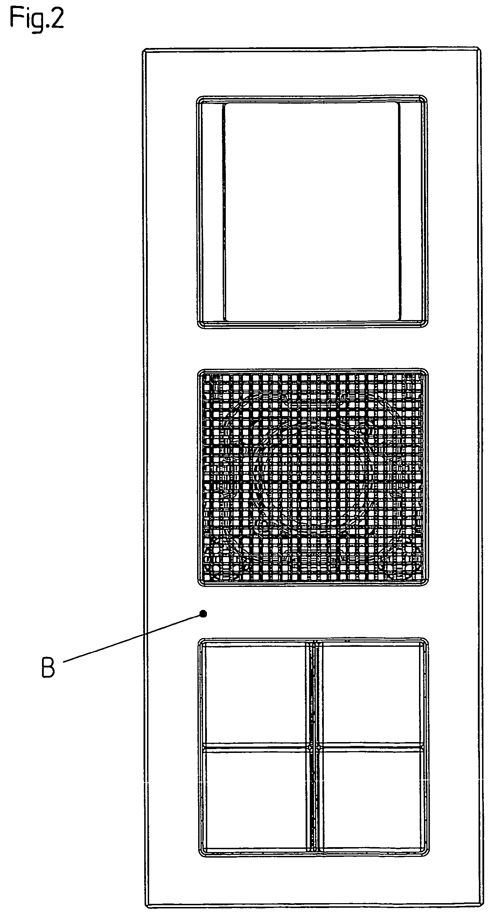

- Fig. 2:: prinziphaft ein gemäß Figur 1 ausgebildetes elektrisches Türkommunikationsgerät in der Draufsicht mit Designabdeckung;

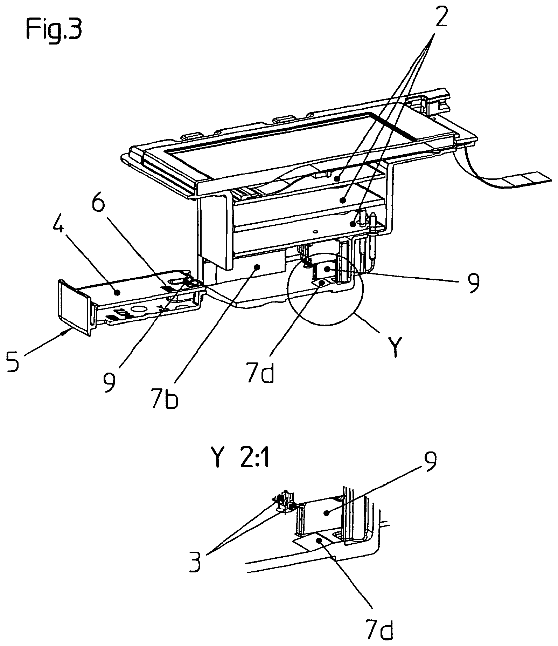

- Fig. 3:: prinziphaft ein gemäß Figur 1 ausgebildetes elektrisches Türkommunikationsgerät als Zusammenbau im Vollschnitt, mit geöffneter Schublade sowie das Detail Y in vergrößerter Darstellung;

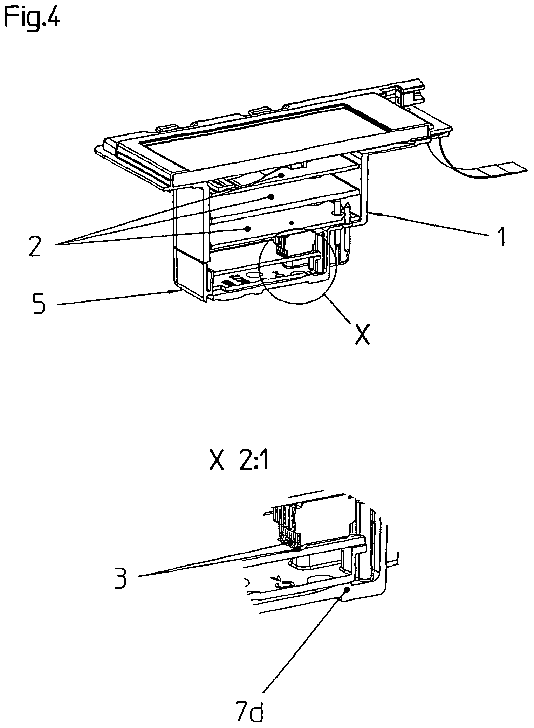

- Fig. 4:: prinziphaft ein gemäß Figur 1 ausgebildetes elektrisches Türkommunikationsgerät als Zusammenbau im Vollschnitt, mit geschlossener Schublade sowie das Detail X in vergrößerter Darstellung;

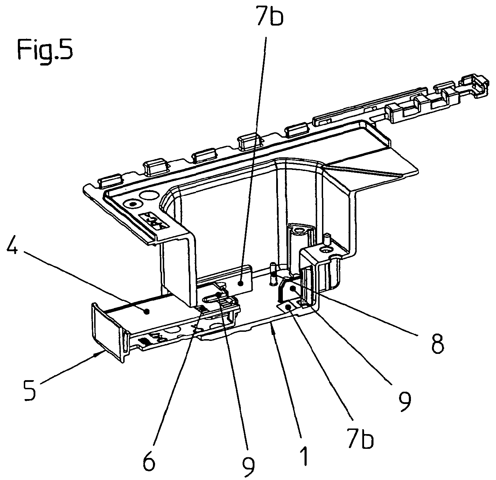

- Fig. 5:: prinziphaft ein gemäß Figur 1 ausgebildetes elektrisches Türkommunikationsgerät als Zusammenbau ohne erste Leiterplatte;

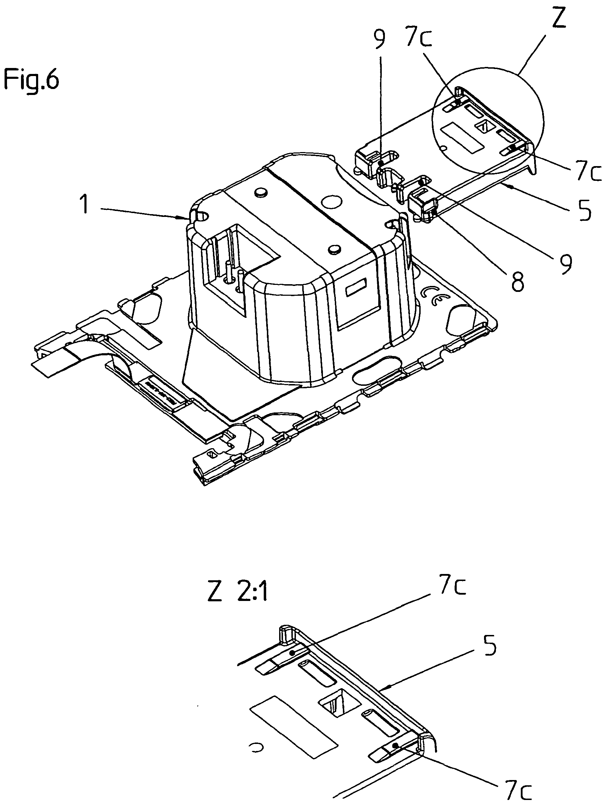

- Fig. 6:: prinziphaft ein gemäß Figur 1 ausgebildetes elektrisches Türkommunikationsgerät im Zusammenbau als Unteransicht, mit geöffneter Schublade sowie das Detail Z in vergrößerter Darstellung.

Wie aus den Zeichnungen hervorgeht, weist ein solches elektrisches Türkommunikationsgerät eine Bedienoberfläche B auf, wobei im zur Aufnahme von Funktionselementen vorgesehenen Gehäuse 1 drei erste Leiterplatten 2 gehalten sind und wobei die untere der drei ersten Leiterplatten 2 mehrere Kontaktelemente 3 zum Anschluss zumindest einer weiteren Leiterplatte 4 aufweist.

Wie des weiteren aus den Figuren hervorgeht, ist im Gehäuse 1 eine Schublade 5 vorhanden, welche bei Bedarf ausgehend von einer geschlossenen Stellung, in eine geöffnete Stellung und umgekehrt gebracht werden kann. Die Schublade 5 ist zur Aufnahme der weiteren Leiterplatte 4 vorgesehen, welche kontaktgebend mit der im Gehäuse 1 gehaltenen zugeordneten ersten Leiterplatte 2 in Verbindung gebracht werden kann. In der geöffneten Stellung der Schublade 5 steht die weitere Leiterplatte 4 nicht kontaktgebend mit der zugeordneten ersten Leiterplatte 2 in Verbindung und kann auf einfache Art und Weise zum Zwecke des Austausches aus der Schublade 5 entnommen werden bzw. ist noch keine weitere Leiterplatte 4 in der Schublade 5 vorhanden, kann diese auf besonders einfache Art und Weise mit einer weiteren Leiterplatte 4 bestückt werden. In der geschlossenen Stellung der Schublade 5 kommen die als Andruckkontakte ausgebildeten Kontaktelemente 3 der ersten Leiterplatte 2 kontaktgebend mit den zugehörigen Kontaktflächen 6 der weiteren Leiterplatte 4 in Verbindung, so dass die zusätzlichen Funktionalitäten in Betrieb genommen werden können oder aber die auf der weiteren Leiterplatte 4 vorhandene Updateversion zur Anwendung gelangen kann. Die Kontaktflächen 6 der weiteren Leiterplatte 4 weisen eine den Kontaktelementen 3 entsprechende Anordnung auf.

Wie des weiteren aus den Figuren hervorgeht, weist sowohl das Gehäuse 1 als auch die Schublade 5 miteinander in Wirkverbindung stehende bzw. kommende Führungselemente 7a, 7 b, 7c, 7d auf. Erste Führungselemente 7a, 7b sind jeweils an zwei gegenüberliegende Seitenwände der Schublade 5 und des Gehäuses 1 angeformt und als Schienensystem ausgeführt, so dass eine exakte Führung für die Schubbewegung der Schublade 5 realisiert ist. Zum einen sind die beiden äußeren Längswände der Schublade 5 als Führungselemente 7a ausgebildet, die zum anderen mit zwei zugeordneten an das Gehäuse 1 angeformten, als Schienenwandungen ausgebildeten Führungselementen 7b zusammenwirken. Zweite Führungselemente 7c, 7d sind an den Boden der Schublade 5 und an die Bodenplatte des Gehäuses 1 angeformt und jeweils als Gleitrampen ausgeführt. Dabei befinden sich zwei als Gleitrampen ausgeführte Führungselemente 7c am Boden der Schublade 5 in der Nähe der Schubladenfrontplatte und ein als Gleitrampe ausgebildetes Führungselement 7d am Einschubende der Bodenplatte des Gehäuses 1. Durch diese Anordnung der als Gleitrampen ausgebildeten zweiten Führungselemente 7c, 7d ist gewährleistet, dass die Schublade 5 kurz bevor sie das Einschubende erreicht, eine Hubbewegung ausführt, so dass die als Andruckkontakte ausgebildeten Kontaktelemente 3 der ersten Leiterplatte 2 kontaktgebend mit den zugehörigen Kontaktflächen 6 der weiteren Leiteplatte 4 in Verbindung kommen. Im umgekehrten Fall, d. h. wenn die Schublade 5 geöffnet wird, erfolgt ganz am Anfang der Zugbewegung ein Absenken der Schublade 5, so dass die als Andruckkontakte ausgebildeten Kontaktelemente 3 der ersten Leiterplatte 2 wieder von den zugehörigen Kontaktflächen 6 der weiteren Leiteplatte 4 entfernt werden, so dass die Kontaktverbindung getrennt ist.

Wie des weiteren aus den Figuren hervorgeht, sind an das Gehäuse 1 und an die Schublade 5 miteinander in Wirkverbindung kommende Rastelemente 8 angeformt damit sichergestellt ist, dass ein unbeabsichtigtes Öffnen der Schublade 5 wirkungsvoll verhindert ist. Außerdem sind am Gehäuse 1 und an der Schublade 5 miteinander in Wirkverbindung tretende Zentrierelemente 9 vorhanden, so dass gewährleistet ist, dass die Kontaktelemente 3 immer zielgenau mit den zugehörigen Kontaktflächen 6 kontaktgebend in Verbindung treten. An das Gehäuse 1 sind zwei stegartig ausgeführte Zentrierelement 9 angeformt, wohingegen in die Schublade 5 zwei Zentrierelemente 9 angeformt sind, welche entsprechend schlitzartig ausgeführt sind. Auch die in der Schublade 5 befindliche weitere Leiterplatte 4 weist zwei solche Zentrierschlitze auf, die zum Zweck der Zentrierung mit den beiden an das Gehäuse 1 angeformten stegartig ausgeführten Zentrierelementen 9 in Wirkverbindung kommen.

Beim vorliegenden Ausführungsbeispiel ist das elektrische Installationsgerät als so genanntes Türkommunikationsgerät ausgeführt. Die in der Schublade 5 befindliche weitere Leiterplatte 4 ist als Kommunikationsschnittstelle aufgeführt, so dass drahtlos über eine Funkverbindung ein Datenaustausch vorgenommen werden kann und zudem die Möglichkeit einer Fernbedienung der Türkommunikationsanlage des Gebäudes auf besonders komfortable Art und Weise realisiert ist. Die als Kommunikationsschnittstelle ausgeführte weitere Leiterplatte 4 ist dabei so ausgelegt, dass über den Bluetooth-Standard die Funkkommunikation mit einem handelsüblichen Handy problemlos möglich ist. Selbstverständlich können je nach Anwendungsfall auch andere Funkstandards, wie z. B. DECT UMTS, GSM, WLAN, Bluetooth, Wimax, Edge, WUSB (Wireless USB) usw. zur Anwendung gelangen. Anstatt eines handelsüblichen Handys kann aber auch ein speziell für diesen Zweck konzipiertes mobiles Gerät eingesetzt werden, über welches dann der Datenaustausch mit einem solchen Türkommunikationsgerät bzw. die Fernbedienung möglich ist. Durch die Möglichkeit der Fernbedienung eröffnet sich dem Benutzer auf komfortable Art und Weise alle Funktionalitäten der Türkommunikationsanlage des Gebäudes nicht nur durch eine vor Ort Bedienung, sondern eben auch durch eine Fernbedienung durchführen zu können. Insbesondere kann der Benutzer von jedem Raum im Gebäude eine Sprechverbindung mit dem Besucher herstellen, falls eine Kamera vorhanden ist ein Standbild oder Videobilder vom Besucher auf seinem Handy anzeigen lassen und danach entscheiden, ob dem Besucher Einlass gewährt wird oder aber nicht. Zu diesem Zweck kann der Benutzer durch eine entsprechende Betätigung einer Taste oder des Touch-Screen-Feldes seines Handys den Türöffner betätigen und somit dem Besucher Einlass gewähren. Soll der Besucher nicht eingelassen werden, kann der Benutzer über das Handy den Besucher entweder eine entsprechende Nachricht zukommen lassen oder aber ohne dass der Besucher informiert wird den Eintritt ins Gebäude verhindern.

Wenn die weitere Leiterplatte 4 als Datenträger ausgeführt ist, kann damit z. B. eine mechanische Schnittstelle RS 232, USB, Seriel, ein Speicher für die Systemsoftware, ein Speicher für einen einfachen Update Vorgang der Systemsoftware oder aber einen Speicher mit wechselbaren Speichermedien für Mediendaten, wie Klingeltöne, Bilder usw. realisiert werden.

## Patentansprüche

1. Elektrisches Türkommunikationsgerät für Gebäude mit einer Bedienoberfläche (B) und mit zumindest einem zur Aufnahme von Funktionselementen vorgesehenen Gehäuse (1), wobei zumindest eine erste Leiterplatte (2) im Gehäuse (1) gehalten ist, welche eine Schnittstelle zum Anschluss zumindest einer weiteren Leiterplatte (4) aufweist, wobei das Gehäuse (1) zur Aufnahme zumindest einer weiteren Leiterplatte (4) zumindest eine in eine offene Stellung und in eine geschlossene Stellung bringbare Schublade (5) aufweist, **dadurch gekennzeichnet, dass** das Gehäuse (1) und die Schublade (5) über Führungselemente (7a, 7b, 7c, 7d) derart miteinander in Verbindung stehen, so dass beim Schließen der Schublade (5) durch eine Schub-Hubbewegung eine kontaktgebende Verbindung zwischen der ersten Leiterplatte (2) und der weiteren Leiterplatte (4) hergestellt wird und die Trennung dieser Kontaktverbindung durch eine Zug-Senkbewegung beim Öffnen der Schublade (5) erfolgt, und dass erste Führungselemente (7a, 7b) jeweils an zwei gegenüberliegende Seitenwände der Schublade (5) und des Gehäuses (1) angeformt und als Schienensystem ausgeführt sind, so dass eine exakte Führung für die Schubbewegung der Schublade (5) realisiert ist, und dass zweite Führungselemente (7c, 7d) an den Boden der Schublade (5) und an die Bodenplatte des Gehäuses (1) angeformt und jeweils als Gleitrampen ausgeführt sind.

2. Elektrisches Türkommunikationsgerät für Gebäude nach Anspruch 1,
**dadurch gekennzeichnet, dass** an zumindest einer ersten Leiterplatte (2) und/oder einer weiteren Leiterplatte (4) zumindest eine Kontaktfläche (6) vorhanden ist.

3. Elektrisches Türkommunikationsgerät für Gebäude nach einem der Ansprüche 1 oder 2, **dadurch gekennzeichnet, dass** an zumindest einer ersten Leiterplatte (2) und/oder einer weiteren Leiterplatte (4) zumindest ein als Schleifkontaktteil ausgebildetes Kontaktelement (3) vorhanden ist.

4. Elektrisches Türkommunikationsgerät für Gebäude nach einem der Ansprüche 1 bis 3, **dadurch gekennzeichnet, dass** an zumindest einer ersten Leiterplatte (2) und/oder einer weiteren Leiterplatte (4) zumindest ein als Andruckkontaktteil ausgebildetes Kontaktelement (3) vorhanden ist.

5. Elektrisches Türkommunikationsgerät für Gebäude nach einem der Ansprüche 1 bis 4, **dadurch gekennzeichnet, dass** zumindest eine weitere Leiterplatte (4) als Datenträger ausgeführt ist.

6. Elektrisches Türkommunikationsgerät für Gebäude nach einem der Ansprüche 1 bis 5, **dadurch gekennzeichnet, dass** zumindest eine weitere Leiterplatte (4) als Kommunikationsschnittstelle ausgeführt ist.

7. Elektrisches Türkommunikationsgerät für Gebäude nach einem der Ansprüche 1 bis 6, **dadurch gekennzeichnet, dass** zumindest ein Teil der Führungselemente (7a, 7b, 7c, 7d) als Nut- und Federanordnung ausgeführt sind.

8. Elektrisches Türkommunikationsgerät für Gebäude nach einem der Ansprüche 1 bis 7, **dadurch gekennzeichnet, dass** an das Gehäuse (1) und an die Schublade (5) miteinander in Wirkverbindung kommende Rastelemente (8) angeformt sind.

9. Elektrisches Türkommunikationsgerät für Gebäude nach einem der Ansprüche 1 bis 8, **dadurch gekennzeichnet, dass** am Gehäuse (1) und an der Schublade (5) mit einander in Wirkverbindung kommende Zentrierelemente (9) vorhanden sind.

## Claims

1. Electric door communication device for buildings with a user interface (B) and with at least one housing (1) to take up the functional elements, wherein at least one first printed circuit board (2) is fixed in the housing (1), the PCB providing an interface for connection of at least one further printed circuit board (4), wherein the housing (1), to take up at least one further printed circuit board (4), provides at least one drawer (5) which can be opened or closed, **characterized by the fact** that the housing (1) and the drawer (5) are connected with one another by guide elements (7a, 7b, 7c, 7d) in a way that during closing of the drawer (5) by a pressing-lifting movement a contacting connection between the first printed circuit board (2) and the further printed circuit board (4) is made and the separation of this contacting connection is effected by a pulling-lowering movement during opening of the drawer (5) and that first guide elements (7a, 7b) respectively are moulded onto two opposite lateral walls of the drawer (5) and the housing (1) and are designed as rail system so that an exact guidance for the pushing movement of the drawer (5) is realised and that second contact elements (7c, 7d) are moulded onto the bottom of the drawer (5) and onto the ground plate of the housing (1) and each are designed as sliding chutes.

2. Electric door communication device for buildings in accordance with Claim 1, **characterized by the fact** that at at least one first printed circuit board (2) and/or a further printed circuit board (4) at least one contact surface (6) is provided.

3. Electric door communication device for buildings in accordance with any of Claims 1 or 2, **characterized by the fact** that at at least one first printed circuit board (2) and/or a further printed circuit board (4) at least one contact element designed as sliding contact part (3) is provided.

4. Electric door communication device for buildings in accordance with any of Claims 1 to 3, **characterized by the fact** that at at least one first printed circuit board (2) and/or a further printed circuit board (4) at least one contact element designed as pressure contact part (3) is provided.

5. Electric door communication device for buildings in accordance with any of Claims 1 to 4, **characterized by the fact** that at least one further printed circuit board (4) is designed as data carrier.

6. Electric door communication device for buildings in accordance with any of Claims 1 to 5, **characterized by the fact** that at least one further printed circuit board (4) is designed as communication interface.

7. Electric door communication device for buildings in accordance with any of Claims 1 to 6, **characterized by the fact** that at least some of the guide elements (7a, 7b, 7c, 7d) are designed as tongue and groove.

8. Electric door communication device for buildings in accordance with any of the Claims 1 to 7, **characterized by the fact** that catching elements (8) in operative connection with one another are moulded onto the housing (1) and the drawer (5).

9. Electric door communication device for buildings in accordance with any of Claims 1 to 8, **characterized by the fact** that centering elements (9) in operative connection with one another are provided at the housing (1) and at the drawer (5).

## Revendications

1. Appareil de communication de porte électrique pour bâtiment avec une interface opérateur (B) et avec au moins un boîtier prévu pour loger des éléments fonctionnels (1), au moins le premier circuit imprimé (2), qui présente une interface de raccordement d'au moins un autre circuit imprimé (4), étant logé dans le boîtier (1), le boîtier (1) destiné à loger au moins un autre circuit imprimé (4) présentant au moins un tiroir (5) en position ouverte et pouvant être mis en position fermée, **caractérisé en ce que** le boîtier (1) et le tiroir (5) sont reliés entre eux par des éléments de guidage (7a, 7b, 7c, 7d) de sorte que, lors de la fermeture du tiroir (5) par un mouvement de poussée et levage, une connexion faisant contact entre le premier circuit imprimé (2) et l'autre circuit imprimé (4) soit établie et que la coupure de cette connexion faisant contact se produise par un mouvement de tirage et d'abaissement en ouvrant le tiroir (5) et que les premiers éléments de guidage (7a, 7b) soient respectivement formés sur deux parois latérales se faisant face du tiroir (5) et du boîtier (1) et soient configurés comme un système de rail et que les seconds éléments de guidage (7c, 7d) soient formés sur le fond du tiroir (5) et sur la plaque de fond du boîtier (1) et soient configurés respectivement comme des rampes de glissement.

2. Appareil de communication de porte électrique pour bâtiment selon la revendication 1 **caractérisé en ce qu**'au moins une surface de contact (6) existe sur au moins un premier circuit imprimé (2) et/ou un autre circuit imprimé (4).

3. Appareil de communication de porte électrique pour bâtiment selon la revendication 1 ou 2 **caractérisé en ce qu**'au moins un élément de contact (3) configuré comme une pièce de balai de contact existe sur au moins un premier circuit imprimé (2) et/ou un autre circuit imprimé (4).

4. Appareil de communication de porte électrique pour bâtiment selon la revendication 1 à 3 **caractérisé en ce qu**'au moins un élément de contact (3) configuré comme une pièce de contact par pression existe sur au moins un premier circuit imprimé (2) et/ou un autre circuit imprimé (4).

5. Appareil de communication de porte électrique pour bâtiment selon l'une des revendications 1 à 4 **caractérisé en ce qu**'au moins un autre circuit imprimé (4) est configuré comme un support de données.

6. Appareil de communication de porte électrique pour bâtiment selon l'une des revendications 1 à 5 **caractérisé en ce qu**'au moins un autre circuit imprimé (4) est configuré comme une interface de communication.

7. Appareil de communication de porte électrique pour bâtiment selon l'une des revendications 1 à 6 **caractérisé en ce qu**'au moins une partie des éléments de guidage (7a, 7b, 7c, 7d) sont configurés comme une disposition en rainure et languette.

8. Appareil de communication de porte électrique pour bâtiment selon l'une des revendications 1 à 7 **caractérisé en ce que** des éléments d'encliquetage (8) interactifs sont formés sur le boîtier (1) et sur le tiroir (5).

9. Appareil de communication de porte électrique pour bâtiment selon l'une des revendications 1 à 8 **caractérisé en ce que** des éléments de centrage (9) interactifs sont formés sur le boîtier (1) et sur le tiroir (5).
